# FASCICULE DE BREVET EUROPEEN

(11) **EP 0 690 575 B1**
(45) Date de publication et mention de la délivrance du brevet: **05.04.2000**
(21) Numéro de dépôt: 95410061.6
(22) Date de dépôt: 21.06.1995
(51) Int. Cl.: H03K 17/687, H03K 17/16

(54) **Dispositif de mise en veille d'une source de polarisation**
Vorrichtung zur Aktivierung einer Vorspannungsquelle
Device for activating a source of bias voltage

(30) Priorité: 27.06.1994 FR 9408118
(43) Date de publication de la demande: 03.01.1996
(73) Titulaire: STMicroelectronics S.A., 94250 Gentilly (FR)
(72) Inventeur: Morche, Colette, F-38240 Meylan (FR)
(74) Mandataire: de Beaumont, Michel

(56) Documents cités:
- EP-A- 0 503 888
- EP-A- 0 515 065
- US-A- 4 713 560

## Description

La présente invention concerne un dispositif de mise en veille d'une source de polarisation. Elle s'applique plus particulièrement à un dispositif faisant appel à un inverseur commandant la désactivation d'une source de polarisation.

Les dispositifs de mise en veille sont utilisés pour réduire l'énergie consommée d'un circuit pendant des périodes de non-utilisation en désactivant la source de polarisation, sans pour autant qu'il soit nécessaire de mettre le circuit hors service. Ils trouvent un intérêt tout particulier dans des dispositifs à alimentation autonome, par exemple constituée de batteries rechargeables ou de piles, tels des capteurs à distance. De tels capteurs ont par exemple pour rôle de transmettre des informations à une centrale en cas de changement de l'état du capteur. Dans de tels dispositifs, il est essentiel de limiter la consommation du capteur pendant les périodes où son état est stable. Pour ce faire, on met en veille la source de polarisation de ses organes d'émission lorsque le capteur est dans un état stable durant un intervalle de temps prédéterminé. Ceci permet de réduire la consommation du dispositif pendant ces périodes. La source de polarisation est réactivée, dès que le signal de commande de mise en veille change d'état, indiquant que le capteur ne se trouve plus dans un état stable.

Classiquement un dispositif de mise en veille d'une source de polarisation est constitué d'un inverseur à base de deux transistors MOS montés entre deux bornes d'alimentation de la source de polarisation.

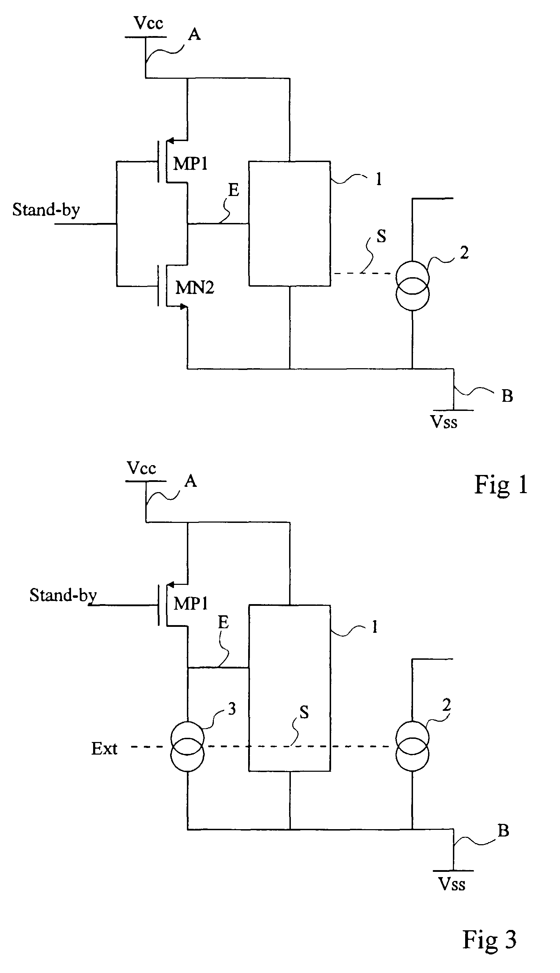

La figure 1 représente un dispositif connu de mise en veille. Une source de polarisation 1 est alimentée par une tension d'alimentation entre deux bornes A, B présentant respectivement des potentiels Vcc et Vss.

La source de polarisation peut être, à titre d'exemple, constituée d'une source de courant en ΔVbe/R. Le détail connu de sa constitution n'est pas représenté. On se bornera à rappeler qu'elle se compose, par exemple, de deux branches de transistors montés en miroirs entre les bornes A et B de la tension d'alimentation. Chaque branche est constituée d'un transistor bipolaire de type NPN et de deux transistors MOS, un premier à canal P et un second à canal N, une résistance de polarisation étant intercalée entre le transistor bipolaire et le premier transistor MOS de la seconde branche.

Les drains des transistors MOS de la première branche constituent une entrée de commande E. Cette entrée de commande E reçoit un signal de commande de mise en veille "Stand-by" par l'intermédiaire d'un inverseur CMOS constitué de deux transistors MOS MP1, MN2. Ces deux transistors MP1, MN2 sont montés entre les deux bornes d'alimentation A, B. La source du transistor MP1 à canal P est connectée à la borne positive d'alimentation A au potentiel Vcc, tandis que son drain est relié au drain du transistor MN2 à canal N. La source du transistor MN2 est connectée à la borne négative d'alimentation B au potentiel Vss. Les deux transistors MP1, MN2 reçoivent sur leurs grilles un signal de commande de mise en veille "Stand-by", tandis que leurs drains constituent la sortie de l'inverseur qui est envoyée sur l'entrée de commande E de la source de polarisation 1.

Le rôle de l'inverseur est d'assurer l'interface entre le reste du circuit et la source de polarisation 1. De plus, il inverse les états du signal de commande de mise en veille "Stand-by" qui est généralement un signal logique dont l'état bas V- représente une demande de mise en veille de la source de polarisation 1. Lorsqu'une demande de mise en veille apparaît, c'est-à-dire lorsque le signal "Stand-by" passe de son état haut à son état bas, la sortie du dispositif de mise en veille, constitué de l'inverseur CMOS MP1, MN2, inverse ce signal. Comme la sortie de l'inverseur est envoyée sur les drains des transistors MOS de la première branche de la source de polarisation 1, cette sortie va bloquer le transistor MOS supérieur de cette branche en portant sa grille au potentiel Vcc, à la chute de tension dans la résistance série du transistor MP1 près. La source de polarisation 1 se trouve alors en veille.

La sortie S d'une telle source de polarisation 1 est constituée par les drains des transistors MOS de la seconde branche. Elle est destinée à activer la polarisation de modules du circuit dans lequel la source de polarisation 1 est implantée au moyen de sources de courant 2 commandées par la source de polarisation 1. Ces sources de courants sont, par exemple, constituées de transistors MOS à canal N montés en miroir sur les transistors MOS inférieurs à canal N de la source de polarisation 1.

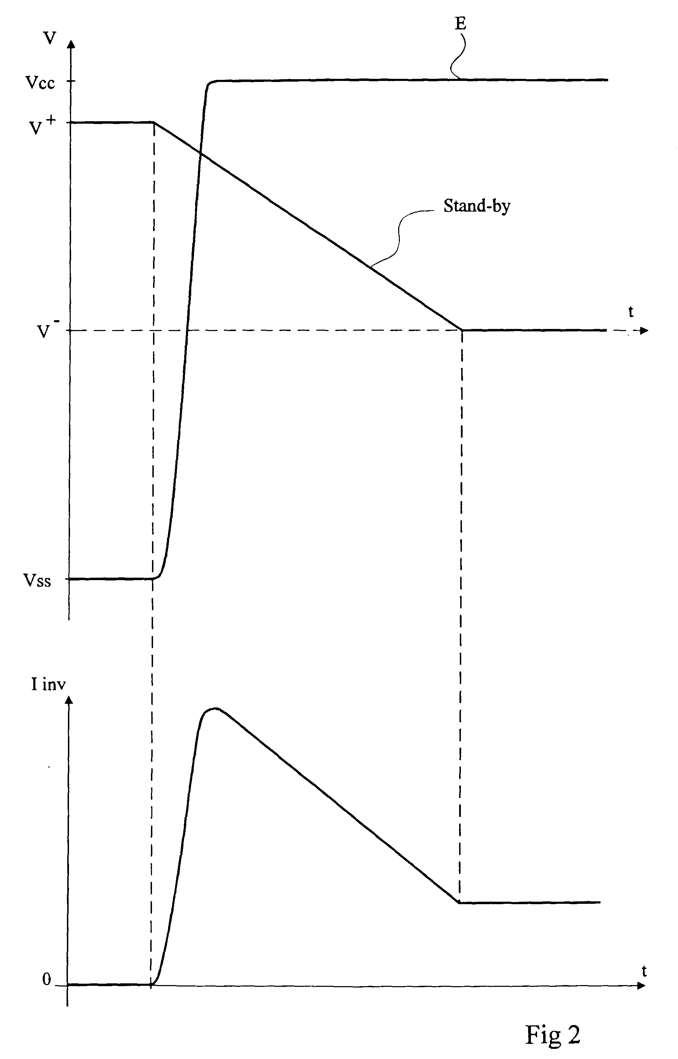

La figure 2 représente, sous forme de chronogrammes, le courant Iinv qui circule dans l'inverseur CMOS en relation avec un exemple de signal de mise en veille "Stand-by", ainsi que le potentiel E de commande de la source de polarisation 1.

Comme on peut le constater, le courant Iinv présente un pic au moment du changement d'état du signal "Stand-by" vers un état de mise en veille. Ce pic s'amortit en suivant le signal de mise en veille "Stand-by". La tension E est bien inversée pour couper la source de polarisation 1, mais le courant qui circule dans l'inverseur entraîne une consommation qui est néfaste pour l'autonomie des dispositifs dans lesquels il est implanté. En effet, si l'amplitude du pic de courant Iinv est maîtrisable par la surface des transistors CMOS qui constituent l'inverseur, sa largeur dépend du signal de mise en veille "Stand-by". De fait, elle dépend du temps de commutation du signal "Stand-by" entre ses deux états logiques.

De surcroît, comme le montre cette figure, il est fréquent que le signal de commande de mise en veille "Stand-by" n'évolue pas entre les deux potentiels Vcc et Vss d'alimentation de la source de polarisation, mais entre deux potentiels intermédiaires V+ et V-. Dans ce cas, la conduction dans l'inverseur est permanente pendant la veille de la source de polarisation 1, ce qui entraîne une consommation résiduelle importante pendant les périodes de veille de la source de polarisation. Il est à noter que la valeur du potentiel V+ doit être supérieure à la valeur Vcc-Vgsp, où Vgsp représente la tension seuil grille-source du transistor MP1, faute de quoi la source de polarisation 1 est en veille permanente.

L'invention vise à réduire l'énergie consommée par un inverseur de ce type, et par ce biais accroître l'autonomie des systèmes à alimentation autonome dans lesquels un dispositif de mise en veille d'une source de polarisation est implanté. Un premier objet est de réduire cette consommation à la commutation de l'inverseur. Un second objet est de rendre le courant qui circule dans l'inverseur indépendant des potentiels des états logiques du signal de commande de mise en veille.

Pour atteindre ces objets, la présente invention prévoit un dispositif de mise en veille d'une source de polarisation à partir d'un signal de commande de mise en veille, comportant un inverseur à charge active commandée par la source de polarisation.

Selon un mode de réalisation de la présente invention, ledit inverseur comprend un premier transistor MOS à canal P, dont la source est connectée à une borne positive de la tension d'alimentation de la source de polarisation, dont le drain constitue la sortie de l'inverseur reliée à une entrée de commande de la source de polarisation, et dont la grille constitue l'entrée de l'inverseur recevant le signal de commande de mise en veille.

Selon un mode de réalisation de la présente invention, le drain du premier transistor est relié à une source de courant, constituant la charge active commandée par la source de polarisation.

Selon un mode de réalisation de la présente invention, la source de courant est constituée d'un second transistor MOS à canal N, dont la source est connectée à une borne négative d'alimentation de la source de polarisation et dont le drain est relié au drain du premier transistor de l'inverseur, la grille du second transistor étant reliée à la sortie de la source de polarisation.

Selon un mode de réalisation de la présente invention, ledit second transistor de l'inverseur est monté en miroir de courant avec un transistor de la source de polarisation.

Selon un mode de réalisation de la présente invention, le signal de commande de mise en veille est un signal logique dont les potentiels d'états sont différents des potentiels présents aux bornes d'alimentation de la source de polarisation, chaque état du signal de commande de mise en veille correspondant à un état, actif ou inactif, de la source de polarisation.

Selon un mode de réalisation de la présente invention, le dispositif comporte en outre des moyens pour réactiver la source de polarisation au passage du signal de commande de mise en veille dans son état correspondant à l'état actif de la source de polarisation.

Selon un mode de réalisation de la présente invention, lesdits moyens de réactivation sont constitués d'une source extérieure délivrant un signal de commande de la charge active, déclenché par le signal de commande de mise en veille, ledit signal de commande de la charge active étant activé pendant la commutation du signal de commande de mise en veille depuis son état correspondant à l'état inactif de la source de polarisation vers son état correspondant à l'état actif de la source de polarisation.

Selon un mode de réalisation de la présente invention, le dispositif est appliqué à une source de polarisation en ΔVbe/R.

Le recours à une charge active dans l'inverseur du signal de commande de mise en veille de la source de polarisation, et le fait que cette charge est commandée par la source de polarisation elle-même, permet de couper la circulation du courant dans l'inverseur dès que la source de polarisation se trouve désactivée.

Ainsi, la largeur du pic de courant lors de la commutation de l'inverseur est considérablement réduite, ce qui limite l'énergie consommée dans cet inverseur pendant la phase de commutation.

De surcroît, le courant qui circule dans l'inverseur est rendu indépendant de la valeur des potentiels des états du signal de commande de mise en veille. La valeur de ce courant est désormais fixée par la source de courant qui constitue la charge active. Ainsi, on réduit sensiblement la consommation d'énergie de l'inverseur dans le cas où les potentiels des états du signal de commande de mise en veille sont différents des potentiels aux bornes d'alimentation de la source de polarisation.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
les figures 1 et 2 décrites précédemment sont destinées à exposer l'état de la technique et le problème posé ;
la figure 3 représente schématiquement un mode de réalisation d'un dispositif de mise en veille selon la présente invention ; et
la figure 4 représente, sous forme de chronogrammes, la forme des tensions et du courant les plus significatifs du dispositif de mise en veille représenté à la figure 3.

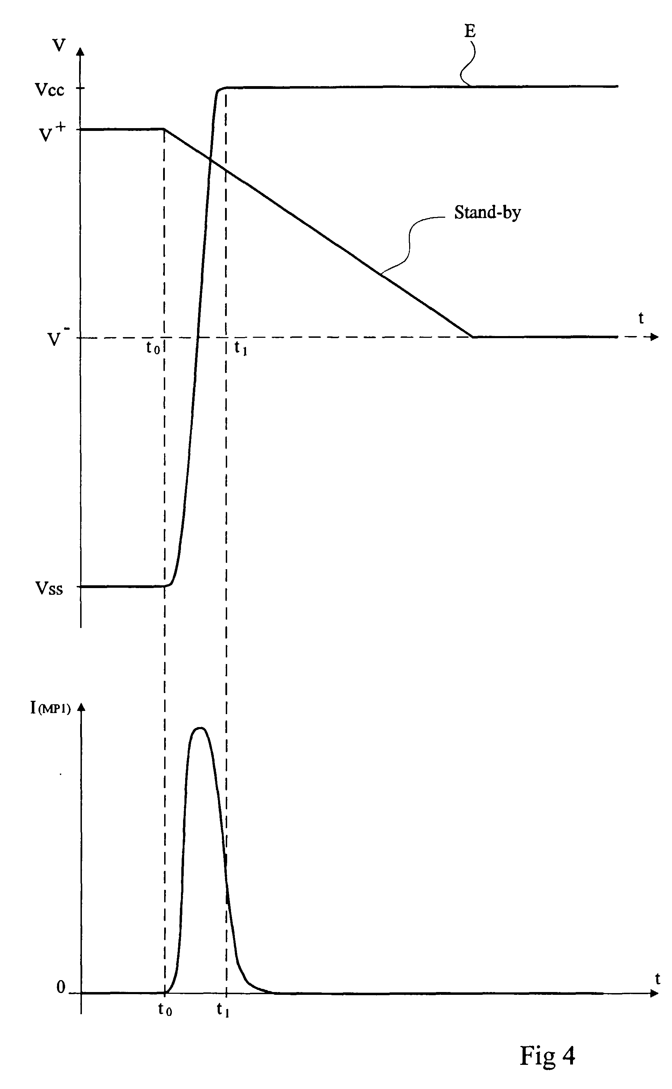

Le dispositif de mise en veille selon l'invention, représenté à la figure 3, est un inverseur à charge active. Il est constitué d'un transistor MOS MP1 dont la source est connectée à une borne positive A au potentiel Vcc d'une tension d'alimentation d'une source de polarisation 1. Le drain de ce transistor MP1 est relié à une borne positive d'une source de courant 3 dont la borne négative est connectée à une borne négative Vss de la tension d'alimentation de la source de polarisation 1. Un signal de commande de mise en veille "Stand-by" est envoyé sur la grille du transistor MP1, tandis que la sortie de l'inverseur est prélevée sur son drain. Cette sortie est envoyée sur une entrée de commande E de la source de polarisation 1. La source de courant 3, constituant la charge active de l'inverseur, est commandée par la sortie S de la source de polarisation 1. Cette commande est réalisée en reproduisant le courant qui traverse une des branches de la source de polarisation 1. En d'autres termes, la source de courant 3 est montée en miroir sur une source de courant de la source de polarisation 1.

On utilise ainsi la sortie S de la source de polarisation 1, qui sert classiquement à activer des sources de courant 2 des modules à polariser, pour commander la charge active 3 de l'inverseur.

Dans le cas où la source de polarisation 1 est une source en ΔVbe/R, la charge active 3 est constituée d'un transistor MOS à canal N monté en miroir sur les transistors MOS inférieurs à canal N de la source de polarisation 1. Le drain de ce transistor est relié au drain du transistor MP1, tandis que sa source est reliée à la borne B de la tension d'alimentation, la grille de ce transistor à canal N étant reliée à la borne de sortie S de la source de polarisation 1. De la sorte, la source de courant 3 est bien commandée par le courant qui circule dans la source de polarisation 1. Toujours dans le cas d'une source de polarisation 1 en ΔVbe/R, son entrée de commande E est constituée par les drains des deux transistors MOS de sa première branche.

Le fonctionnement de ce dispositif de mise en veille est illustré par la figure 4. Cette figure 4 représente, sous forme de chronogrammes, le courant I(MP1) circulant dans le transistor MP1 en relation avec le signal "Stand-by" et le potentiel de l'entrée de commande E de la source de polarisation 1 qui correspond au potentiel du drain du transistor MP1.

Le signal "Stand-by" est un signal à deux états entre deux potentiels V+ et V-. En l'absence de mise en veille, c'est-à-dire, tant que le signal "Stand-by" est au potentiel V+, aucun courant ne circule dans le transistor MP1. Dès que le signal "Stand-by", en transitant vers son état bas V-, passe sous le potentiel Vcc-Vgsp (instant t0), le transistor MP1 entre en conduction. Cela provoque un pic du courant I(MP1) dont l'amplitude dépend de la source de courant 3. Dès que la chute de la tension sur la sortie de l'inverseur est suffisante pour désactiver la source de polarisation 1 (instant t1), le signal envoyé par cette dernière sur la source de courant 3 disparaît. En effet, comme plus aucun courant ne circule dans la source de polarisation 1, aucun courant ne peut être reproduit sur la source de courant 3. De ce fait, le courant I(MP1) dans le transistor MP1 devient nul. On rend ainsi la largeur du pic de courant I(MP1) indépendante de la largeur de transition du signal "Stand-by". De surcroît, même si ce signal varie, comme cela est représenté, entre deux potentiels V+, V- différents de la tension d'alimentation de la source de polarisation 1, aucun courant ne circule dans l'inverseur.

Lorsque le signal de commande de mise en veille "Stand-by" revient dans son état haut, correspondant à une demande d'état actif pour la source de polarisation 1, il est nécessaire de provoquer le redémarrage de la source de polarisation 1.

Pour ce faire, il est nécessaire de forcer la conduction dans la source de courant 3, afin que le potentiel de l'entrée de commande E de la source de polarisation 1 puisse être porté à une valeur permettant la remise en conduction des transistors MOS supérieurs à canal P de la source de polarisation 1. Cette polarisation des transistors MOS supérieurs de la source de polarisation 1 est réalisée par l'inverseur lorsque le signal "Stand-by" en transitant vers son état haut V+, repasse au-dessus du potentiel Vcc-Vgsp, mais à condition qu'un courant puisse circuler dans l'inverseur.

Plusieurs solutions peuvent être mises en oeuvre pour permettre ce redémarrage.

On peut par exemple, comme cela est représenté à la figure 3, appliquer sur l'entrée de commande de la source de courant 3, un signal de commande "Ext" provenant d'une source extérieure. Ce signal "Ext" peut être un créneau d'amplitude suffisante pour remettre en conduction la charge active 3. La largeur de ce créneau est, par exemple, initialisée par le front montant du signal "Stand-by" et finalisée par le front descendant du signal présent sur l'entrée de commande E de la source de polarisation 1. En dehors de ces périodes, aucun signal extérieur n'est appliqué sur la source de courant 3 constituant la charge active, de sorte qu'elle est alors commandée uniquement par la source de polarisation 1. Le signal de commande "Ext" a uniquement pour rôle de forcer la conduction dans la charge active 3 et ainsi permettre la conduction dans l'inverseur lorsque le signal de commande de mise en veille "Stand-by" revient dans son état haut V+.

On pourrait également, par exemple, appliquer sur l'entrée de commande de la source de courant 3 une tension continue de faible valeur indépendante du signal "Stand-by". Cela aurait alors pour effet de maintenir la charge active 3 de l'inverseur en permanence en conduction, mais avec une valeur de courant indépendante du signal "Stand-by". Cette valeur de courant de maintien peut être choisie très faible.

Comme on vient de le voir, l'invention permet de réduire la consommation d'énergie d'un dispositif de mise en veille, sans nuire au principe de fonctionnement de la mise en veille d'une source de polarisation. Cette réduction de consommation est d'autant plus importante que la différence entre l'état bas V- du signal de commande de mise en veille "Stand-by" et le potentiel Vss de la borne négative B de la source de polarisation 1 est importante. La largeur du pic du courant qui circule dans l'inverseur ne dépend plus que du temps de commutation des transistors qui constituent la source de polarisation 1.

En outre, l'invention permet, par un effet secondaire, de commander la mise en veille au moyen d'un signal "Stand-by" sous forme d'impulsions. En effet, avec les montages connus, il est nécessaire que le signal de commande de mise en veille soit continu, faute de quoi la source de polarisation redémarre. Désormais, une impulsion du signal de mise en veille suffit pour désactiver la source de polarisation 1. De fait, tant qu'un signal forçant la conduction de la charge active 3 n'est pas appliqué, la source de polarisation 1 reste désactivée quelle que soit l'évolution du signal de commande de mise en veille.

Bien entendu, la présente invention est susceptible de diverses variantes et modifications qui apparaîtront à l'homme de l'art. En particulier, dans la description qui précède, l'état haut, respectivement bas, du signal de commande de mise en veille a été supposé correspondre à l'état actif, respectivement inactif, de la source de polarisation. L'inverse peut aisément être mis en oeuvre, par exemple en inversant le signal de commande de mise en veille. De plus chacun des composants décrits pour réaliser les constituants de l'inverseur pourra être remplacé par un ou plusieurs éléments remplissant la même fonction. En outre, la source de polarisation, décrite à titre d'exemple comme une source en ΔVbe/R, peut être une source de type quelconque.

## Revendications

1. Dispositif de mise en veille d'une source de polarisation (1) à partir d'un signal de commande de mise en veille ("Stand-by"), comportant un inverseur, caractérisé en ce que l'inverseur comprend une charge active (3) commandée par une sortie (S) de la source de polarisation (1).

2. Dispositif de mise en veille selon la revendication 1, caractérisé en ce que ledit inverseur comprend un premier transistor MOS à canal P (MP1), dont la source est connectée à une borne positive (A) de la tension d'alimentation de la source de polarisation (1), dont le drain constitue la sortie de l'inverseur reliée à une entrée de commande (E) de la source de polarisation (1), et dont la grille constitue l'entrée de l'inverseur recevant le signal de commande de mise en veille ("Stand-by").

3. Dispositif de mise en veille selon la revendication 2, caractérisé en ce que le drain du premier transistor (MP1) est relié à une source de courant (3), constituant la charge active commandée par la sortie (S) de la source de polarisation (1).

4. Dispositif de mise en veille selon la revendication 3, caractérisé en ce que la source de courant (3) est constituée d'un second transistor MOS à canal N, dont la source est connectée à une borne négative (B) d'alimentation de la source de polarisation (1) et dont le drain est relié au drain du premier transistor (MP1) de l'inverseur, la grille du second 'transistor étant reliée à la sortie (S) de la source de polarisation (1).

5. Dispositif selon la revendication 4, caractérisé en ce que ledit second transistor de l'inverseur est monté en miroir de courant avec un transistor de la source de polarisation (1).

6. Dispositif selon la revendication 4 ou 5, caractérisé en ce que le signal de commande de mise en veille ("Stand-by") est un signal logique dont les potentiels d'états (V+, V-) sont différents des potentiels (Vcc, Vss) présents aux bornes (A, B) d'alimentation de la source de polarisation (1), chaque état du signal de commande de mise en veille ("Stand-by") correspondant à un état, actif ou inactif, de la source de polarisation (1).

7. Dispositif de mise en veille selon la revendication 6, caractérisé en ce qu'il comporte en outre des moyens pour réactiver la source de polarisation (1) au passage du signal de commande de mise en veille ("Stand-by") dans son état correspondant à l'état actif de la source de polarisation (1).

8. Dispositif de mise en veille selon la revendication 7, caractérisé en ce que lesdits moyens de réactivation sont constitués d'une source extérieure délivrant un signal de commande ("Ext") de la charge active (3), déclenché par le signal de commande de mise en veille ("Stand-by"), ledit signal de commande ("Ext") de la charge active (3) étant activé pendant la commutation du signal de commande de mise en veille ("Stand-by") depuis son état (V-) correspondant à l'état inactif de la source de polarisation (1) vers son état (V+) correspondant à l'état actif de la source de polarisation (1).

9. Dispositif de mise en veille selon l'une quelconque des revendications 1 à 8, caractérisé en ce qu'il est appliqué à une source de polarisation (1) en ΔVbe/R.

## Patentansprüche

1. Vorrichtung zum Einschalten eines Bereitschaftszustands bei einer Vorspannungsquelle (1) durch ein Steuersignal für den Bereitschaftszustand ("Stand-by"), die einen Inverter aufweist, dadurch gekennzeichnet, dass der Inverter eine aktive Last (3) aufweist, die von einem Ausgang (S) der Vorspannungsquelle (1) gesteuert wird.

2. Vorrichtung zum Einschalten eines Bereitschaftszustandes nach Anspruch 1, dadurch gekennzeichnet, dass der Inverter einen ersten MOS-Transistor (MP1) mit P-Kanal aufweist, dessen Quelle an einen positiven Anschluss (A) der Versorgungsspannung der Vorspannungsquelle (1) angeschlossen ist, dessen Senke den Ausgang des Inverters bildet, der an einen Steuereingang (E) der Vorspannungsquelle (1) angeschlossen ist und dessen Gate den Eingang des Inverters bildet, der das Steuersignal für den Bereitschaftszustand ("Stand-by") empfängt.

3. Vorrichtung zum Einschalten eines Bereitschaftszustandes nach Anspruch 2, dadurch gekennzeichnet, dass die Senke des ersten Transistors (MP1) an eine Stromquelle (3) angeschlossen ist, welche die aktive Last darstellt, die durch den Ausgang (S) der Vorspannungsquelle (1) gesteuert wird.

4. Vorrichtung zum Einschalten eines Bereitschaftszustandes nach Anspruch 3, dadurch gekennzeichnet, dass die Stromquelle (3) einen zweiten MOS-Transistor mit N-Kanal aufweist, dessen Quelle an einen negativen Versorgungsanschluss (B) der Vorspannungsquelle (1) angeschlossen ist und dessen Senke an die Senke des ersten Transistors (MP1) des Inverters angeschlossen ist, wobei das Gate des zweiten Transistors an den Ausgang (S) der Vorspannungsquelle (1) angeschlossen ist.

5. Vorrichtung nach Anspruch 4, dadurch gekennzeichnet, dass der zweite Transistor des Inverters als Stromspiegel zu einem Transistor der Vorspannungsquelle (1) ausgebildet ist.

6. Vorrichtung nach Anspruch 4 oder 5, dadurch gekennzeichnet, dass das Steuersignal für den Bereitschaftszustand ("Stand-by") ein logisches Signal ist, dessen Potentialzustände (V+, V-) sich von den Potentialen (Vcc, Vss), die an den Versorgungsanschlüssen (A, B) der Vorspannungsquelle (1) anliegen, unterscheiden, wobei jeder Zustand des Steuersignals für den Bereitschaftszustand ("Stand-by") einem Zustand, aktiv oder inaktiv, der Vorspannungsquelle (1) entspricht.

7. Vorrichtung zum Einschalten eines Bereitschaftszustandes nach Anspruch 6, dadurch gekennzeichnet, dass sie ausserdem Mittel aufweist, um beim Übergang des Steuersignals für den Bereitschaftszustand ("Stand-by") in seinen Zustand, der dem aktiven Zustand der Vorspannungsquelle (1) entspricht, die Vorspannungsquelle (1) zu reaktivieren.

8. Vorrichtung zum Einschalten eines Bereitschaftszustandes nach Anspruch 7, dadurch gekennzeichnet, dass die Mittel zur Reaktivierung von einer äusseren Quelle gebildet werden, die ein Steuersignal ("Ext") für die aktive Last (3) abgibt, das von dem Steuersignal für den Bereitschaftszustand ("Stand-by") ausgelöst wird, wobei das Steuersignal ("Ext") für die aktive Last (3) aktiv ist, während das Steuersignal für den Bereitschaftszustand ("Stand-by") von dem Zustand (V-), der dem inaktiven Zustand der Vorspannungsquelle (1) entspricht, auf den Zustand (V+), der dem aktiven Zustand der Vorspannungsquelle (1) entspricht, umschaltet.

9. Vorrichtung zum Einschalten eines Bereitschaftszustandes nach einem der Ansprüche 1 bis 8, dadurch gekennzeichnet, dass sie bei einer Vorspannungsquelle (1) mit ΔVbe/R eingesetzt wird.

## Claims

1. A device for setting a bias source (1) at stand-by through a stand-by control signal ("Stand-by") comprising an inverter characterized in that the inverter comprises an active load (3) controlled by an output (S) of the bias source (1).

2. The device of claim 1, characterized in that said inverter comprises a first P-channel MOS transistor (MP1) whose source is connected to a positive terminal (A) of the supply voltage of the bias source (1), whose drain constitutes the inverter output connected to a control input (E) of the bias source (1), and whose gate constitutes the inverter input receiving the stand-by control signal ("Stand-by") .

3. The device of claim 2, characterized in that the drain of the first transistor (MP1) is connected to a current source (3), constituting the active load controlled by output (S) of the bias source (1).

4. The device of claim 3, characterized in that the current source (3) comprises a second N-channel MOS transistor whose source is connected to a negative supply terminal (B) of the bias source (1), and whose drain is connected to the drain of the first transistor (MP1) of the inverter, the gate of the second transistor being connected to the output (S) of the bias source (1).

5. The device of claim 4, characterized in that said second transistor of the inverter is connected as a current mirror with a transistor of the bias source (1).

6. The device of claim 4 or 5, characterized in that the stand-by control signal ("Stand-by") is a logic signal having states whose potentials (V+, V-) differ from the potentials (Vcc, Vss) present at the supply terminals (A, B) of the bias source (1), each state of the stand-by control signal ("Stand-by") corresponding to a state, active or inactive, of the bias source (1).

7. The device of claim 6, characterized in that it further comprises means to reactivate the bias source (1) at the switching of the stand-by control signal ("Stand-by") to its state corresponding to the active state of the bias source (1).

8. The device of claim 7, characterized in that said reactivating means comprise an external source producing a control signal ("Ext") for the active load (3), triggered by the stand-by control signal ("Stand-by"), said control signal ("Ext") for the active load (3) being active during the switching of the stand-by control signal ("Stand-by") from its state (V-) associated with the inactive state of the bias source (1) to its state (V+) associated with the active state of the bias source (1) .

9. The device of any of claims 1 to 8, characterized in that it is applied to a ΔVbe/R bias source (1).
